# EUROPÄISCHE PATENTSCHRIFT

(11) **EP 3 740 771 B1**
(45) Veröffentlichungstag und Bekanntmachung des Hinweises auf die Patenterteilung: **09.02.2022**
(21) Anmeldenummer: 18811190.0
(22) Anmeldetag: 23.11.2018
(51) Int. Cl.: G01R 31/3167, G01R 31/317

(54) **ELEKTRISCHE SCHALTUNG ZUM TEST PRIMÄRER INTERNER SIGNALE EINES ASIC**
ELECTRICAL CIRCUIT FOR TESTING PRIMARY INTERNAL SIGNALS ON AN ASIC
CIRCUIT ÉLECTRIQUE POUR TESTER DES SIGNAUX INTERNES PRIMAIRES D'UN ASIC

(30) Priorität: 17.01.2018 DE 102018200723
(43) Veröffentlichungstag der Anmeldung: 25.11.2020
(73) Patentinhaber: Robert Bosch GmbH, 70442 Stuttgart (DE)
(72) Erfinder: HERMANN, Carsten, 72762 Reutlingen (DE)
(86) Internationale Anmeldenummer: PCT/EP2018/082345
(87) Internationale Veröffentlichungsnummer: WO 2019/141417

(56) Entgegenhaltungen:
- EP-A2- 0 239 929
- US-A1- 2003 006 811
- US-A1- 2017 077 003

## Beschreibung

Die vorliegende Erfindung betrifft eine elektrische Schaltung zum Test primärer interner Signale eines ASIC, wobei lediglich ein Test-Pin vorgesehen ist, über welchen eine Auswahl eines oder mehrerer zu beobachtender digitaler Signale oder eine Auswahl eines analogen Signals durchführbar ist.

### Stand der Technik

Anwendungsspezifische integrierte Schaltungen (englisch: application-specific integrated circuits, ASIC) werden im Zuge ihres Fertigungsprozesses und vor ihrer Auslieferung getestet. Dafür müssen interne digitale und/oder analoge Signale über eine Test-Schnittstelle beobachtbar beziehungsweise messbar bereitgestellt werden können. Das ASIC wird dazu im Allgemeinen in einen Testmodus versetzt, in dem die digitalen und/oder analogen Signale über einen Multiplexer auf einen oder mehrere gesonderte Anschlüsse des ASIC geschaltet werden können. Die Auswahl der in der Regel nacheinander zu testenden Signale kann beispielsweise über die Serial Peripheral Interface (SPI)-Schnittstelle oder mittels einer Schnittstelle gemäß dem IEEE-Standard 1149.1 (auch bekannt als: Joint Test Action Group, JTAG) erfolgen. Dies bedingt bisher, dass wesentliche Teile der ASIC-Infrastruktur wie beispielsweise die interne Spannungsversorgung, die Spannungsreferenz, die Kommunikationsschnittstelle und der Digitalteil des ASIC oder zumindest Bereiche des Digitalteils des ASIC sowie Teile des Analogteils in Betrieb sind.

Dadurch kann die Testbarkeit - insbesondere die der primären internen Testgrößen wie beispielsweise der primären Spannungsversorgung, der primären Spannungsreferenz und der Reset-Signale der primären Spannungsversorgung - eines ASIC eingeschränkt werden.

Sollen primäre interne Signale eines ASIC über die Test-Schnittstelle nach außen geführt werden können, ist ein sorgfältiges und mitunter aufwendiges Design erforderlich, um sicherzustellen, dass der Normalbetrieb des ASIC, insbesondere dessen Hochlauf durch die Testbarkeit der entsprechenden Signale nicht gefährdet wird. Soll beispielsweise das Reset-Signal der primären internen Spannungsversorgung getestet werden können, so muss die Auswirkung dieses Reset-Signals im Testbetrieb mitunter unterdrückt beziehungsweise maskiert werden können. Eine Unterdrückung im Normalbetrieb würde jedoch die normale Funktion des ASIC beeinträchtigen. Es muss daher sichergestellt werden, dass derartige Signale im Normalbetrieb nicht beeinträchtigt werden.

Sollen des Weiteren interne analoge Spannungen, wie zum Beispiel die primäre interne Spannungsreferenz, über einen dezentralen Analog-Multiplexer nach außen geführt werden, ist sicherzustellen, dass diese Signale im Normalbetrieb nicht beeinträchtigt werden können. Im Hochlauf falsch angesteuerte Transmissionsgatter eines verteilten Multiplexers könnten beispielsweise die primäre interne Spannungsreferenz mit einem anderen zu testenden Signal kurzschließen und so den Hochlauf verhindern, auch wenn die falsche Ansteuerung nur kurzzeitig erfolgt.

Beispielsweise kann es unter Umständen ebenfalls nicht möglich sein, ein Reset-Signal einer internen primären Spannungsversorgung oder ein Power-on-Reset-Signal über die Testschnittstelle zu beobachten, wenn die interne primäre Spannung dabei zu Testzwecken so klein sein muss, dass die aus dieser internen primären Spannungsversorgung abgeleitete Spannungsversorgung für den Digitalteil nicht ausreicht, um diesen zu betreiben.

Das Dokument US 2003/0006811 A1 offenbart eine integrierte Halbleiterschaltungsvorrichtung.

### Offenbarung der Erfindung

Erfindungsgemäß wird daher eine elektrische Schaltung zum Test primärer interner Signale eines ASIC zur Verfügung gestellt, wobei lediglich ein Test-Pin vorgesehen ist, über welchen eine Auswahl eines oder mehrerer zu beobachtender digitaler Signale oder eines analogen Signals durchführbar ist.

Durch eine auf diese Weise ermöglichte messtechnische Erfassung des Stromes, der in den Test-Pin-Anschluss hineinfließt, kann auf den Zustand des zu beobachtenden Signals bzw. der zu beobachtenden Signale geschlossen werden. Eine derartige Schaltung ist besonders geeignet, die vorgenannten primären Testgrößen wie die primäre Spannungsversorgung, die primäre Spannungsreferenz und die Reset-Signale der primären Spannungsversorgung eines ASIC zu testen.

Dabei ist erfindungsgemäß ein zwischen dem Test-Pin und einem Ausgangsanschluss der elektrischen Schaltung angeordneter Schmitt-Trigger vorgesehen, wobei bei einem Überschreiten einer Schaltschwelle des Schmitt-Triggers eine Aktivierung eines Testmodus vorgesehen ist. Ferner umfasst die elektrische Schaltung gemäß der vorliegenden Erfindung wenigstens eine zur Beobachtung eines digitalen Signals vorgesehene Teilschaltung mit einem Widerstand, einem NMOS-Transistor sowie einem UND-Gatter, an dessen ersten Eingang das digitale Signal anliegt. Dabei ist der Widerstand zwischen dem Test-Pin und dem Drain-Anschluss des NMOS-Transistors angeordnet, der Source-Anschluss des NMOS-Transistors ist mit Masse verbunden, der Gate-Anschluss des NMOS-Transistors ist mit dem Ausgang des UND-Gatters verbunden und der zweite Eingang des UND-Gatters ist mit dem Ausgangsanschluss der elektrischen Schaltung verbunden.

### Vorteile der Erfindung

Die vorgeschlagene Schaltung ist prinzipiell dazu geeignet - in Abhängigkeit von der entsprechenden Realisierungsform - jedes beliebige interne digitale Signal und entsprechend einer bevorzugten Ausführungsform auch jedes beliebige interne analoge Signal eines ASIC zu testen.

Besonders vorteilhaft an der Schaltung ist, dass die ASIC-Infrastruktur nur insoweit betriebsbereit sein muss, dass während des Tests eines digitalen oder analogen Signals lediglich eine interne Spannungsversorgung zur Verfügung steht. Neben dieser Spannungsversorgung und den entsprechend der Ausführungsbeispiele vorgeschlagenen Schaltungen müssen keine weiteren Schaltungsteile des ASIC betriebsbereit sein.

Insbesondere muss der Digitalteil des ASIC nicht funktionsbereit sein, sondern kann sich im Reset befinden. Eine Kommunikations-Schnittstelle, welche vom Digitalteil des ASIC bedient wird, ist ebenfalls nicht erforderlich.

Gegenüber den aus dem Stand der Technik bekannten Lösungen erfolgen erfindungsgemäß die Kommunikation zum eventuellen Umschalten in einen besonderen Testmodus, die Kommunikation zur Auswahl eines der zu beobachtenden digitalen oder analogen Signale sowie die messtechnische Erfassung dieser Signale über einen einzigen Anschluss des ASIC.

Dadurch wird es ermöglicht, dass die primären Testgrößen - oder beliebige andere digitale oder analoge Signale - gewissermaßen in ihrer normalen Funktion, also im Normalbetrieb, getestet beziehungsweise beobachtet werden. Beispielsweise ist das Maskieren von Reset-Signalen daher nicht erforderlich. Entsprechend kann sich das Design eines ASIC zur Darstellung der eigentlichen Funktion vereinfachen.

Der Test-Pin kann erfindungsgemäß als bidirektionale Schnittstelle aufgefasst werden, weil über diesen durch Anlegen unterschiedlich hoher Spannungen in einer geeigneten zeitlichen Abfolge eine Information, insbesondere was genau messtechnisch erfasst werden soll bzw. welcher Test-Mode aktiviert werden soll, in das ASIC hinein übertragen werden kann. Des Weiteren kann der Test-Pin aber auch Informationen über interne Signale in Form eines Stromes, welcher in diesen hineinfließt, bereitstellen.

Jedes interne digitale Signal ändert vorliegend entsprechend der Formel I_{TEST} = U_{TEST}/ R×[1/2⁰ + 1/(D₁×2¹) + 1/(D₂×2²) + ... + 1/(Dₙ×2ⁿ)] gewichtet den Strom. Wenn alle digitalen Signale LOW sind, fließt nur der Strom I_{TEST} = U_{TEST} / R×1/2⁰ in den Test-Pin hinein. Ist beispielsweise das interne digitale Signal D₁ = HIGH, so fließt zusätzlich der Strom I_{TEST} = U_{TEST} / R×1/2¹ in den Test-Pin hinein. In analoger Weise fließt bei einem internen digitalen Signal D² = HIGH zusätzlich der Strom I_{TEST} = U_{TEST} / R×1/2² in den Test-Pin hinein. Die Ströme sind gewichtet und überlagern sich. Auf diese Weise kann durch messtechnische Erfassung des Stromes gleichzeitig bzw. parallel auf die Zustände aller internen digitalen Signale geschlossen werden. Demnach ist die Gewichtung der Ströme wesentlich für eine gleichzeitige bzw. parallele Erfassung der internen digitalen Signale, so dass eine entsprechende Gewichtung der verwendeten Widerstände für eine Funktion der Schaltung zu beachten ist.

Wird anstelle aller internen digitalen Signale D₁, ..., Dₙ eines der analogen Signale A₁, ..., Aₘ ausgewählt, so kann auf dessen internen Spannungswert geschlossen werden, indem der Strom gemessen wird, der in den Test-Pin hineinfließt. Dieser ergibt sich zu I_{TEST}=U_{TEST}/R+U_{A}/R, wobei UA der Spannungswert des einen ausgewählten internen analogen Signals A₁, ..., Aₘ ist.

Die Auswahl dessen, was am Test-Pin messtechnisch erfasst werden kann, nämlich entweder alle digitalen Signale D₁, D₂, ..., Dₙ gleichzeitig über gewichtete Ströme oder eines der analogen Signale A₁, A₂, ..., Aₘ über einen zur Spannung des Signals proportionalen Strom, als auch die Auswahl eines Test-Mode, erfolgt über ein Protokoll, das ebenfalls über den Test-Pin des ASIC in das ASIC übertragen wird. Dies geschieht, indem die Information darüber, was messtechnisch erfasst werden soll bzw. welcher Test-Mode aktiviert werden soll, aus den unterschiedlich hohen Spannungspegeln am Test-Pin mit Hilfe eines Spannungsteilers und mit Hilfe von Schmitt-Triggern und Komparatoren detektiert und von einer Logik ausgewertet wird.

In einer besonderen Ausführungsform ist erfindungsgemäß vorgesehen, dass die elektrische Schaltung ferner einen zwischen dem Test-Pin und Masse angeordneten Widerstand umfasst, dessen Wert ermittelt werden kann, indem der Strom gemessen wird, der in den Test-Pin hineinfließt, solange die Spannung am Test-Pin unterhalb der Schaltschwelle des Schmitt-Triggers liegt. Durch das Bekanntsein dieses Wertes und die Messung des Stromes, der in den Test-Pin hineinfließt, ist es im Folgenden möglich, auf die Zustände interner digitaler und analoger Signale schließen zu können.

Gemäß einer weiteren Ausführungsform ist die elektrische Schaltung ferner ausgebildet zur Beobachtung von analogen Signalen und umfasst einen Operationsverstärker, eine einen Schmitt-Trigger aufweisende Schaltung zur Begrenzung der Eingangsspannung am Test-Pin sowie wenigstens eine zur Beobachtung des analogen Signals vorgesehene Teilschaltung. Auf diese Weise kann zusätzlich ein Test von analogen Signalen für die erfindungsgemäße Schaltung zum Test eines ASIC ermöglicht werden.

Dabei umfasst gemäß einer bevorzugten Ausgestaltung die zur Beobachtung des analogen Signals vorgesehene Teilschaltung einen zwei D-Flipflops aufweisenden Zähler und für jedes zu beobachtende analoge Signal einen ein UND-Gatter aufweisenden Decoder sowie ein Transmissionsgatter. Hierdurch wird es ermöglicht, dass je nach Zählerstand (00, 01, 10 oder 11) der D-Flipflops eines der UND-Gatter an seinem Ausgang einen HIGH-Pegel führt ,damit den EN-Eingang des entsprechenden Transmissionsgatters ansteuert, sodass selbiges eine niederohmige Verbindung zwischen seinen beiden anderen Anschlüssen herstellt. Bevorzugter Weise kann der Zähler auch aus mehr als zwei D-Flipflops aufgebaut sein. Entsprechend können dann m = 2^{d}-1 analoge Signale A₁, ..., Aₘ beobachtet werden, wobei d die Anzahl der D-Flipflops ist. Als Decoder ist ein klassischer 1-aus-m-Decoder in allgemein bekannter Bauweise vorgesehen, welcher im Stand der Technik auch als 1-aus-n-Decoder bezeichnet wird, bestehend aus 2^{d} UND-Gattern mit jeweils d Eingängen, wobei das UND-Gatter, dessen Eingänge alle mit den invertierten Ausgängen Q' der D-Flipflops verbunden sind, zur Auswahl der Beobachtung aller digitalen Signale gleichzeitig vorgesehen ist.

Bevorzugter Weise sind ein erster Eingang des jeweiligen UND-Gatters mit dem nicht-invertierten bzw. dem invertierten Ausgang eines ersten der D-Flipflops, ein zweiter Eingang des jeweiligen UND-Gatters mit dem nicht-invertierten bzw. dem invertierten Ausgang eines zweiten der D-Flipflops und der Ausgang des jeweiligen UND-Gatters mit einem Eingang zur Steuerung des jeweiligen Transmissionsgatters verbunden. Dadurch wird erreicht, dass die verwendeten D-Flipflops die Zählerstände 00, 01, 10 und 11 einnehmen können, sodass auf diese Weise verschiedene interne analoge Signale zur Beobachtung auswählbar sind.

Gemäß einer bevorzugten Ausgestaltung der elektrischen Schaltung ist ferner ein ODER-Gatter vorgesehen, dessen erster Eingang mit dem nicht-invertierten Ausgang des ersten der wenigstens zwei D-Flipflops, dessen zweiter Eingang mit dem nicht-invertierten Ausgang des zweiten der wenigstens zwei D-Flipflops und dessen Ausgang mit einem Eingang zur Steuerung des Operationsverstärkers verbunden ist. Der Vorteil einer solchen Ausgestaltung ist, dass basierend auf den von den D-Flipflops ausgegebenen Signalen eine Steuerung des Operationsverstärkers erfolgen kann und auf diese Weise der Strom, welcher in den Test-Pin der elektrischen Schaltung fließt, von dem jeweils ausgewählten internen analogen Signal beeinflusst wird.

In einer weiteren vorteilhaften Ausgestaltung ist für die erfindungsgemäße elektrische Schaltung ferner ein UND-Gatter vorgesehen, dessen erster Eingang mit dem invertierten Ausgang des ersten der wenigstens zwei D-Flipflops, dessen zweiter Eingang mit dem invertierten Ausgang des zweiten der wenigstens zwei D-Flipflops verbunden ist und dessen Ausgang mit einem jeweils dritten Eingang des wenigstens einen UND-Gatters, welches in der für die Beobachtung eines digitalen Signals vorgesehenen Teilschaltung angeordnet sind, verbunden ist. Dadurch kann erreicht werden, dass die Ausgänge der UND-Gatter, welche der Beobachtung eines digitalen Signals dienen, auf LOW gesetzt werden können und so keines der digitalen Signale den Strom, der in den Test-Pin des ASIC fließt, beeinflussen kann. So kann ausschließlich eine Beobachtung analoger Signale erfolgen.

Vorteilhafterweise sind bei der Schaltung zur Begrenzung der Eingangsspannung am Test-Pin deren Eingang zwischen zwei Widerständen eines zwischen Test-Pin der elektrischen Schaltung und Masse angeordneten Spannungsteilers angeordnet und deren Ausgang mit dem Taktsignal-Eingang eines D-Flipflops verbunden.

In einer bevorzugten Ausgestaltung der Erfindung ist der Ausgangsanschluss der elektrischen Schaltung mittels eines Inverters invertiert und jeweils mit einem Clear-Eingang eines D-Flipflops verbunden. Dadurch kann der Zählerstand der D-Flipflops wieder zurückgesetzt werden, da mittels des HIGH-Pegels des Inverters die D-Flipflops über Clear-Eingänge zurückgesetzt werden können.

Besonders bevorzugt umfasst die elektrische Schaltung ferner zwei Komparatoren zur Auswahl der zu messenden digitalen oder analogen Signale über den Test-Pin und zur Aktivierung unterschiedlicher Testmodi. Eine solche Ausgestaltung ist insbesondere vorteilhaft, weil eine derart realisierte elektrische Schaltung verschiedene Testmodi beziehungsweise Testmethoden ermöglicht und sich ferner leicht auf den Betrieb mit mehreren Anschlüssen erweitern lässt, über welche auf die gleiche Art und Weise Signale ausgewählt und beobachtet werden können.

Dabei liegt vorteilhafterweise an dem positiven Eingang der Komparatoren jeweils eine Referenzspannung an und der negative Eingang der Komparatoren ist jeweils mit dem Test-Pin verbunden. Es besteht die Möglichkeit, die Komparatoren zu deaktivieren und deshalb die internen digitalen und/oder analogen Signale zu testen, auch wenn Betriebsspannung oder Referenzspannung nicht ihre Zielwerte eingenommen haben, sodass beispielsweise messtechnisch erfassbar wird, ab welcher internen Versorgungsspannung die interne Referenzspannung ihren Zielwert erreicht oder ein internes Power-on-Reset-Signal seinen Zustand ändert.

Bevorzugter Weise ist zwischen dem negativen Eingang der Komparatoren und dem Test-Pin der elektrischen Schaltung jeweils eine aus einem Transistor sowie aus einem Widerstand und einem Kondensator bestehende Schaltung vorgesehen. Dies ermöglicht einen Schutz der Komparator-Eingänge vor zu hohen Spannungen an ihren Eingängen sowie eine Filterung und Verzögerung der Eingangssignale.

Gemäß einer weiteren bevorzugten Ausgestaltung ist in der elektrischen Schaltung ferner ein D-Flipflop vorgesehen, dessen Taktsignal-Eingang mit dem Ausgang des Schmitt-Triggers verbunden ist und dessen nicht-invertierter Ausgang jeweils mit einem Eingang zur Steuerung des jeweiligen Komparators verbunden ist.

Alternativ ist mit Vorteil vorgesehen, dass die elektrische Schaltung zwei D-Flipflops umfasst, welche zur Bereitstellung von Ausgangssignalen vorgesehen sind. Eine Ausgabe derartiger Ausgangssignale ist vorteilhaft, da diese im ASIC dazu verwendet werden können, um bestimmte Testbedingungen zu schaffen.

Alternativ kann ein aus D-Flipflops bestehendes Schieberegister zur Auswahl der zu testenden Signale und zur Einstellung eines Test-Modes vorgesehen sein.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 ein Ausführungsbeispiel einer elektrischen Schaltung zum Test digitaler Signale,
Figur 2 ein Ausführungsbeispiel einer elektrischen Schaltung zum Test digitaler und analoger Signale,
Figur 3 ein Ausführungsbeispiel einer elektrischen Schaltung zum Test digitaler und analoger Signale mit Möglichkeit zur Aktivierung verschiedener Testmodi, und
Figur 4 einen Signalverlauf zu dem vorgenannten Ausführungsbeispiel einer elektrischen Schaltung zum Test digitaler und analoger Signale mit Möglichkeit zur Aktivierung verschiedener Testmodi gemäß Figur 3.

### Ausführungsformen der Erfindung

Im Rahmen der Beschreibung der Ausführungsbeispiele der Erfindung werden die Spannungen bezogen auf Masse GND an Anschlüssen beziehungsweise Netzen beispielsweise mit U_{TEST} für den Anschluss TEST beziehungsweise U_{VDD} für das Netz VDD bezeichnet. Ströme hingegen, welche in Anschlüsse hineinfließen, werden beispielsweise mit I_{TEST} für den ASIC-Anschluss TEST bezeichnet.

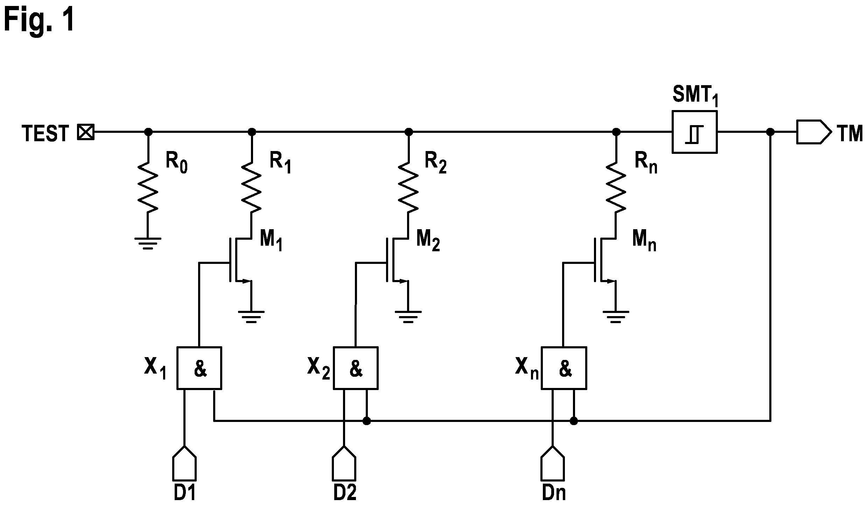

In Figur 1 ist ein Ausführungsbeispiel einer elektrischen Schaltung zum Test digitaler Signale gezeigt, welches gemäß einer ersten schaltungstechnischen Realisierungsform lediglich zum Testen interner digitaler Signale geeignet ist. Über den ASIC-Anschluss TEST kann beim Anlegen einer Spannung, die größer als die Schaltschwelle des Schmitt-Triggers SMT₁ ist, in den Testmodus gewechselt werden. Dies wird durch einen High-Pegel am Ausgangsanschluss TM des Schaltkreises, der mit dem Ausgang des Schmitt-Triggers SMT₁ verbunden ist, angezeigt. Der Schmitt-Trigger SMT₁ und die UND-Gatter X₁ bis Xₙ werden von einer Versorgungsspannung U_{VDD} versorgt, welche in Figur 1 nicht dargestellt ist. Die Schaltschwellen des Schmitt-Triggers liegen typischerweise bei 2/3 beziehungsweise bei 1/3 der Versorgungsspannung U_{VDD}.

Wird die Spannung U_{TEST} am ASIC-Anschluss TEST von 0 V an bis zur Betriebsspannung von U_{VDD} erhöht, so bleibt der Ausgang des Schmitt-Triggers SMT₁ auf einem niedrigen LOW-Pegel, bis seine Eingangsspannung beziehungsweise die Spannung U_{TEST} am ASIC-Anschluss TEST oberhalb der Schaltschwelle von typischerweise 2/3×U_{VDD} liegt. Solange ist es möglich, den Wert des Widerstandes R₀=2⁰×R mithilfe des Ohm'schen Gesetzes zu bestimmen, indem der Strom I_{TEST}, der in den ASIC-Anschluss TEST bei der an diesem Anschluss angelegten Spannung U_{TEST} fließt, bestimmt wird. Der Widerstand ergibt sich zu R₀=R=U_{TEST}/I_{TEST}.

Sobald das Signal am Ausgangsanschluss TM=HIGH ist, bestimmen die internen digitalen Signale D₁ bis Dₙ des ASIC den zusätzlichen Strom, welcher in den ASIC-Anschluss TEST hineinfließt, indem die Transistoren M₁ bis Mₙ die Widerstände R₁ bis Rₙ mit der Masse GND verbinden. Steigen die Werte der Widerstände R₁ bis Rₙ wie in Figur 1 beispielsweise mit R₁=2¹×R, R₂=2²×R, ..., Rₙ=2ⁿ×R an, so kann durch Messen des Gesamtstromes, der in den ASIC-Anschluss TEST hineinfließt und unter Berücksichtigung von R₀=R ermittelt werden, welche der internen digitalen Signale D₁ bis Dₙ einen HIGHbeziehungsweise LOW-Pegel führen, da für den am ASIC-Anschluss TEST messbaren Strom I_{TEST} während TM=HIGH gilt: I_{TEST} = U_{TEST} / R × [1/2⁰ + 1/(D₁×2¹) + 1/(D₂×2²) + ... + 1/(Dₙ×2ⁿ)], wobei in diese Formel für D₁ ... Dₙ eine 1 beziehungsweise eine 0 für einen logischen HIGH- beziehungsweise LOW-Pegel einzusetzen ist. Da die Größen U_{TEST} und R bekannt sind, können über den gemessenen Strom I_{TEST} so die Zustände der digitalen Signale D₁ bis Dₙ bestimmt werden.

Wird die Spannung am ASIC-Anschluss TEST von U_{VDD} bis auf 0 V reduziert, so bleibt der Ausgang des Schmitt-Triggers SMT₁ solange auf einem HIGH-Pegel bis seine Eingangsspannung beziehungsweise die Spannung am ASIC-Anschluss TEST unterhalb der Schaltschwelle von typischerweise 1/3×U_{VDD} liegt. Dann ist TM=LOW und die internen digitalen Signale D₁ bis Dₙ haben keinen Einfluss mehr auf den Gesamtstrom, welcher in den ASIC-Anschluss TEST hineinfließt.

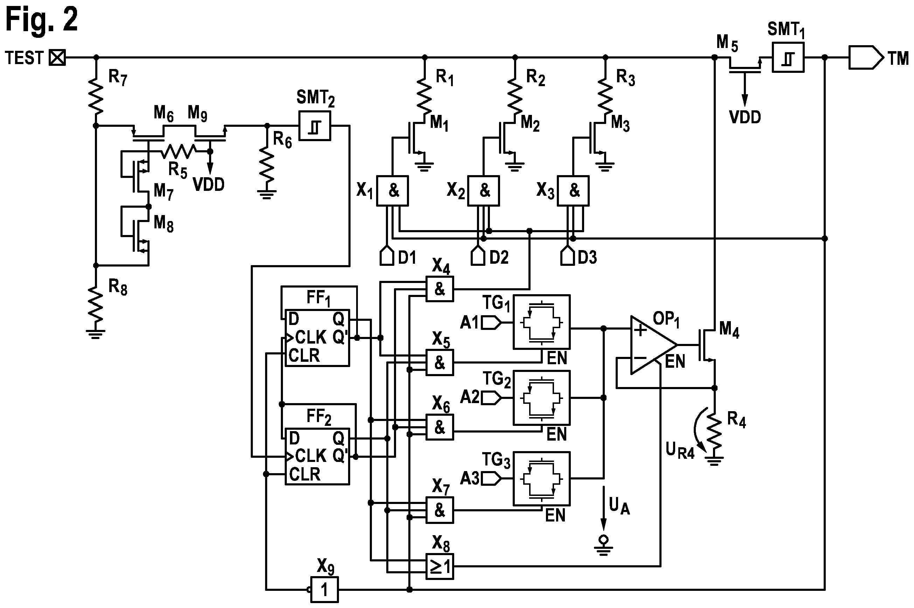

In Figur 2 ist ein Ausführungsbeispiel einer elektrischen Schaltung zum Test digitaler und analoger Signale dargestellt, bei welchem die aus Figur 1 bekannte Schaltung um die Testbarkeit interner analoger Spannungssignale erweitert wurde, wobei dies in Figur 2 bespielhaft für drei digitale Signale D₁ bis D₃ und drei analoge Signale A₁ bis A₃ dargestellt ist. Der Strom, der in den ASIC-Anschluss TEST hineinfließt, kann nun zusätzlich von der Spannung U_{A1} bis U_{A3} eines der analogen Signale A₁ bis A₃ beeinflusst werden, indem eines dieser Signale über eines der Transmissionsgatter TG₁ bis TG₃ auf den positiven Eingang des mithilfe des Transistors M₄ als Impedanzwandler arbeitenden Operationsverstärkers OP₁ geführt wird. Der Operationsverstärker OP₁ steuert dabei das Gate des Transistors M₄ in der Weise an, dass sich die Eingangsdifferenzspannung zwischen seinem positiven und seinem negativen Eingang zu 0 V ergibt. Die Spannung U_{A} am positiven Eingang des Operationsverstärkers OP₁ entspricht so dem Spannungsabfall U_{R4} über dem Widerstand R₄=R. Entsprechend fließt durch den Widerstand R₄ ein Strom I_{R4}=U_{A}/R, welcher proportional zu der Spannung U_{A1} bis UA3 des ausgewählten analogen Spannungssignals A₁ bis A₃ ist.

Welches der internen analogen Signale A₁ bis A₃ am ASIC-Anschluss TEST messtechnisch erfassbar ist, wird von dem Zähler, bestehend aus den D-Flipflops aus FF₁ und FF₂ sowie dem aus den UND-Gattern X₅ bis X₇ bestehenden Decoder bestimmt. Je nach Zählerstand (01, 10 oder 11) führt eines der UND-Gatter an seinem Ausgang einen HIGH-Pegel und steuert damit den EN-Eingang (enable) des entsprechenden Transmissionsgatters TG₁ bis TG₃ an, sodass dies eine niederohmige Verbindung zwischen seinen beiden anderen Anschlüssen herstellt. Die Transmissionsgatter, deren EN-Eingang auf einem LOW-Pegel liegen, sind entsprechend hochohmig.

Ist der Zählerstand nicht 00, so ist der Ausgang des ODER-Gatters X₈ HIGH und der Operationsverstärker OP₁ arbeitet in der zuvor beschriebenen Weise. Gleichzeitig sind auch der Ausgang des UND-Gatters X₄ und damit auch die Ausgänge der UND-Gatter X₁ bis X₃ auf LOW geschaltet, sodass keines der digitalen Signale D₁ bis D₃ den Strom, welcher in den ASIC-Anschluss TEST hineinfließt, beeinflussen kann. Der Strom, der in den ASIC-Anschluss TEST hineinfließt, ergibt sich zu I_{TEST}=U_{TEST}/R+U_{A}/R, wobei UA einer Spannung U_{A1} bis U_{A3} entsprechend dem Zählerstand entspricht. Da die Größen U_{TEST} und R bekannt sind, kann über den gemessenen Strom I_{TEST} so die Spannung des ausgewählten internen analogen Signals bestimmt werden.

Ist der Zählerstand hingegen 00, so ist der Ausgang des ODER-Gatters X₈ auf LOW und der Operationsverstärker OP₁ ist deaktiviert. Der Ausgang des hier verwendeten Operationsverstärkers OP₁ liegt dann auf 0 V. Alternativ oder zusätzlich könnte der positive Eingang des Operationsverstärkers OP₁ von einem Transistor auf Masse GND gezogen werden (nicht dargestellt in Figur 2). Beim Zählerstand 00 ist auch der Ausgang des UND-Gatters X₄ auf HIGH, sodass die digitalen Signale D₁ bis D₃ den Strom, der in den ASIC-Anschluss TEST hineinfließt, wie für Figur 1 beschrieben beeinflussen können.

Der Zählerstand wird mit jeder steigenden Flanke des Ausgangssignals des Schmitt-Triggers SMT₂ inkrementiert. Ist der Zählerstand 11 erreicht, wird er mit der nächsten steigenden Flanke am CLK-Eingang des D-Flipflops FF₂ wieder auf 00 gesetzt. Mit TM=LOW wird er ebenfalls auf 00 gesetzt, weil der HIGH-Pegel des Inverters Xg die D-Flipflops FF₁ und FF₂ über ihre CLR-Eingänge (clear) zurücksetzt (die Ausgänge Q der D-Flipflops sind dann LOW).

Der Ausgang des Schmitt-Triggers SMT₂ wechselt von LOW auf HIGH, wenn seine Eingangsspannung über die Schaltschwelle von typischerweise 2/3×U_{VDD} steigt. Er wechselt von HIGH auf LOW, wenn seine Eingangsspannung unter die Schaltschwelle von typischerweise 1/3×U_{VDD} sinkt. Über die Transistoren M₆ und M₉ sowie den aus R₇ und R₈ gebildeten Spannungsteiler, wobei R₇=R₈=R/2, ist der Eingang des Schmitt-Triggers SMT₂ mit dem ASIC-Test-Pin TEST verbunden. Damit der Transistor M₆ leiten kann, muss die Spannung an seinem Source-Anschluss um die Schwellspannung U_{THP} eines PMOS-Transistors oberhalb der Versorgungsspannung U_{VDD} liegen. Dies ist in der Schaltung gemäß Figur 2 der Fall, wenn U_{TEST}≥2×(U_{VDD}+U_{THP}) ist. Ist U_{TEST} kleiner, dann sperrt M₆ und der Eingang des Schmitt-Triggers SMT₂ wird von R₆ auf GND gezogen. Mit jedem Spannungspuls, dessen Amplitude größer als 2×(U_{VDD}+U_{THP}) ist, wird der Zähler demnach inkrementiert.

Die Transistoren M₅ und M₉ dienen dem Schutz der Schmitt-Trigger SMT₁ und SMT₂. Sie begrenzen die Eingangsspannung jeweils auf maximal U_{VDD}-U_{THN}, wobei U_{THN} die Schwellspannung eines NMOS-Transistors ist. Der Widerstand R₅ und die Transistoren M₇ und M₈ hingegen begrenzen die Source-Gate-Spannung von M₆. Ist die Spannung am ASIC-Anschluss TEST so groß, dass die Drain-Body-Diode von M₇ leitet und sich ein Kanal in M₈ ausbilden kann, wird das Gate-Potential von M₆ angehoben, sodass die Source-Gate-Spannung von M₆ nicht wesentlich größer werden kann als die Summe aus der Schwellspannung eines PMOS-Transistors und der Flussspannung einer Drain-Body-Diode.

Das Ausführungsbeispiel gemäß Figur 2 beschränkt sich auf drei analoge Signale A₁, A₂, A₃. Durch Hinzufügen weiterer Transmissionsgatter, D-Flipflops und durch Erweiterung des 1-aus-m-Decoders ist jedoch prinzipiell eine beliebige Anzahl von analogen Signalen beobachtbar. Sollen demnach mehr als drei interne analoge Signale beobachtbar sein, so muss der 1-aus-m-Dekoder gemäß den vorstehenden Ausführungen erweitert werden. Entsprechend sind bei mehr als drei analogen Signalen und mehr als zwei D-Flipflops auch die nicht-invertierten Ausgänge der weiteren D-Flipflops an zusätzliche Eingänge des ODER-Gatters und die invertierten Ausgänge der weiteren D-Flipflops an zusätzliche Eingänge des UND-Gatters anzuschließen.

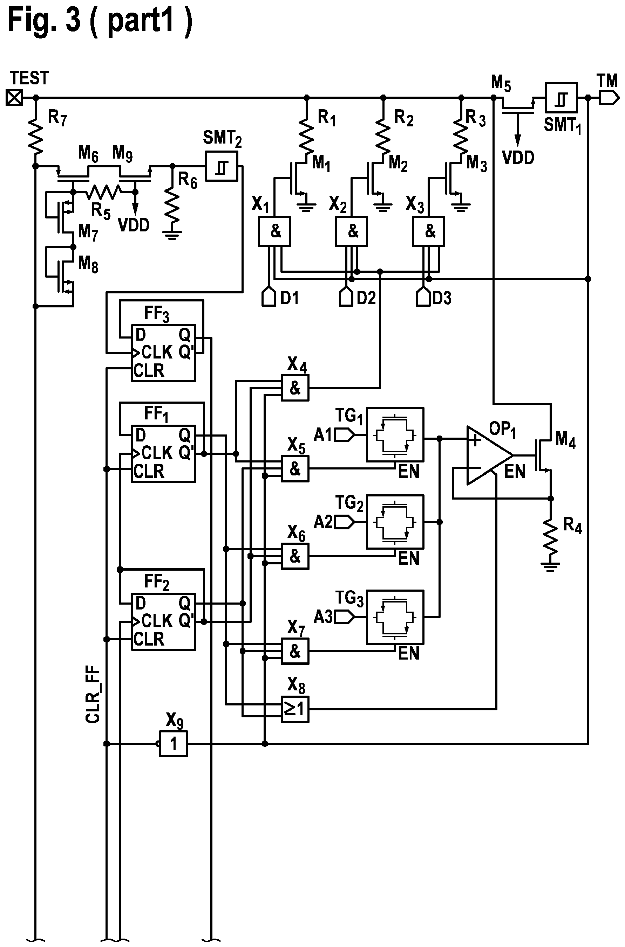

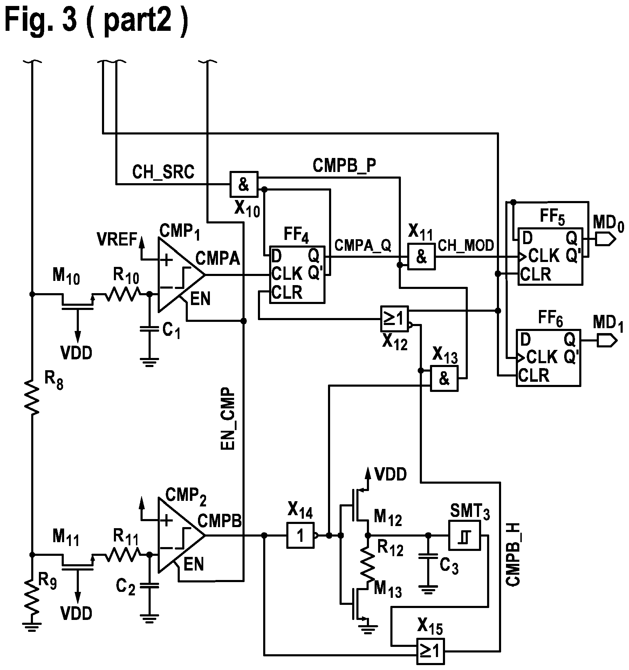

In Figur 3 ist ein Ausführungsbeispiel einer elektrischen Schaltung zum Test digitaler und analoger Signale mit der Möglichkeit zur Aktivierung verschiedener Testmodi dargestellt, bei welchem die in Figur 2 dargestellte Schaltung entsprechend erweitert wurde. Durch eine derartige Schaltung wird es möglich, über den ASIC-Anschluss TEST zusätzlich zu der Testbarkeit interner digitaler und analoger Signale auch verschiedene Testmodi zu aktivieren.

Es wird darauf hingewiesen, dass prinzipiell der in Figur 2 dargestellte Ansatz, bei welchem verschieden hohe Ansprechschwellen für mehrere Schmitt-Trigger geschaffen werden, weiterverfolgt werden könnte. Da sich jedoch die interne Versorgungsspannung U_{VDD} während des Tests auch verändern kann (insbesondere nach unten), müsste dann die Spannung U_{TEST} am ASIC-Anschluss TEST ratiometrisch zur internen Versorgungsspannung U_{VDD} mitgeführt werden, was mitunter nicht möglich sein kann, da die interne Versorgungsspannung eventuell nicht über einen separaten ASIC-Anschluss messbar ist.

Es kann daher von Vorteil sein, neben dem Schmitt-Trigger SMT₁, der zur Aktivierung des Testmodus dient, einen weiteren Schmitt-Trigger mit einer sehr hohen Ansprechschwelle zu verwenden, sodass auch eine erhebliche Reduktion der internen Versorgungsspannung U_{VDD} nicht dazu führen kann, dass dieser Schmitt-Trigger bei gleichbleibender Spannung U_{TEST} am ASIC-Anschluss TEST und stark reduzierter interner Versorgungsspannung U_{VDD} ungewollt schaltet. Die Verwendung mehrerer Schmitt-Trigger mit sehr hohen Ansprechschwellen ist dennoch möglich, verlangt aber von den Komponenten, welche im ASIC mit dem ASIC-Anschluss TEST intern verbunden sind, mitunter eine sehr hohe Spannungsfestigkeit.

Bei der in Figur 3 dargestellten Schaltung wird daher neben dem Schmitt-Trigger SMT₁ zur Aktivierung des Testmodus ein weiterer Schmitt-Trigger SMT₂ mit einer sehr hohen Ansprechschwelle verwendet. Auch diese Schaltung realisiert bespielhaft die Testbarkeit von drei digitalen Signalen D₁ bis D₃ und drei analogen Signalen A₁ bis A₃. Zusätzlich können vier verschiedene Testmodi aktiviert werden.

Der Ausgang des Schmitt-Triggers SMT₂ wechselt von LOW auf HIGH, wenn seine Eingangsspannung über die Schaltschwelle von typischerweise 2/3×U_{VDD} steigt. Er wechselt von HIGH auf LOW, wenn seine Eingangsspannung unter die Schaltschwelle von typisch 1/3×U_{VDD} sinkt. Über die Transistoren M₆ und M₉ und den Spannungsteiler aus R₇ bis Rg, wobei R₇=2R/3 und R₈=R/12 und Rg=R/4, ist der Eingang des Schmitt-Triggers SMT₂ mit dem ASIC-Test-Pin TEST verbunden. Damit der Transistor M₆ leiten kann, muss die Spannung an seinem Source-Anschluss um die Schwellspannung U_{THP} eines PMOS-Transistors oberhalb der Versorgungsspannung U_{VDD} liegen. Das ist in der Schaltung gemäß Figur 3 der Fall, wenn U_{TEST}≥3×(U_{VDD}+U_{THP}) ist. Ist U_{TEST} kleiner, dann sperrt M₆ und der Eingang des Schmitt-Triggers SMT₂ wird von R₆ auf Masse GND gezogen. Mit jedem Spannungspuls, dessen Amplitude größer als 3×(U_{VDD}+U_{THP}) ist, schaltet das D-Flipflop FF₃ seinen Ausgang Q von LOW auf HIGH (beziehungsweise von HIGH auf LOW). Mit TM=LOW werden alle D-Flipflop FF₁ bis FF₆ auf Q=LOW gesetzt, weil der HIGH-Pegel des Inverters Xg die D-Flipflops FF₁ bis FF₆ über ihre CLR-Eingänge (clear) zurücksetzt (die Ausgänge Q der D-Flipflops sind dann LOW).

Ist der Ausgang des D-Flipflops (Netz EN_CMP) LOW, so sind die Komparatoren CMP₁ und CMP₂ deaktiviert. Die Ausgänge der hier verwendeten Komparatoren sind dann LOW. Ist der Ausgang des D-Flipflops HIGH, so sind die Komparatoren CMP₁ und CMP₂ aktiviert. Mithilfe der Komparatoren CMP₁ und CMP₂ ist es durch Variation der Spannung am ASIC-Test-Pin TEST zum einen möglich, auszuwählen, ob die digitalen Signale D₁ bis D₃ oder eines der analogen Signale A₁ bis A₃ über den ASIC-Anschluss TEST messtechnisch erfassbar sein sollen. Zum anderen ist es möglich, unterschiedliche Testmodi zu aktivieren. Aufgrund der Möglichkeit, die Komparatoren CMP₁ und CMP₂ zu deaktivieren, können die internen Signale D₁ bis D₃ beziehungsweise A₁ bis A₃ auch getestet werden, wenn die Betriebsspannung U_{VDD} oder die Referenzspannung U_{VREF} nicht ihre Zielwerte eingenommen haben. Es ist so beispielsweise über den ASIC-Anschluss TEST messtechnisch erfassbar, ab welcher internen Versorgungsspannung U_{VDD} die interne Referenzspannung U_{VREF} ihren Zielwert erreicht oder ein internes Power-on-Reset-Signal seinen Zustand ändert, ohne das die Gefahr bestünde, dass einer der Komparatoren CMP₁ und CMP₂ ungewollt schalten könnte.

Die aktivierten Komparatoren CMP₁ und CMP₂ liefern HIGH-Pegel, wenn die Spannung an ihrem jeweiligen negativen Eingang kleiner als die Referenzspannung U_{VREF} ist. Die Widerstände R₁₀ und R₁₁ sowie die Kondensatoren C₁ und C₂ dienen als Filter und Verzögerungsglieder. Die Transistoren M₁₀ und M₁₁ schützen die Komparator-Eingänge vor zu hohen Spannungen an ihren Eingängen, indem sie diese auf maximal U_{VDD}-U_{THN} begrenzen, wobei U_{THN} die Schwellspannung eines NMOS-Transistors ist. Unter Berücksichtigung des Spannungsteilers aus den Widerständen R₇ bis Rg sind die Komparator-Ausgänge von CMP₁ beziehungsweise CMP₂ entsprechend bei einer Spannung U_{TEST}>3×U_{VREF} beziehungsweise U_{TEST}>4×U_{VREF} auf HIGH, andernfalls ist der jeweilige Komparator-Ausgang auf LOW.

In den Ausführungsbeispielen gemäß Figur 2 und Figur 3 werden sowohl die Flipflops FF₁ und FF₂ als auch die Flipflops FF₄, FF₅ und FF₆ zurückgesetzt. Die Flipflops FF₁ und FF₂ wählen dabei entweder alle digitalen Signale gleichzeitig aus (Zählerstand 00) oder eines der analogen Signale (Zählerstand 01, 10, 11). Die Flipflops FF₅ und FF₆ sind hingegen zur Auswahl eines Test-Mode vorgesehen.

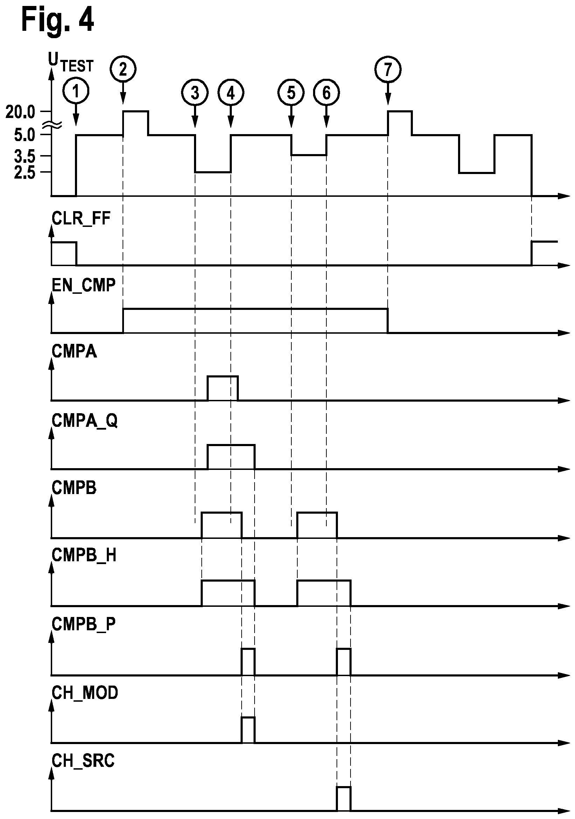

In Figur 4 ist der Signalverlauf zu dem vorgenannten Ausführungsbeispiel einer elektrischen Schaltung zum Test digitaler und analoger Signale mit Möglichkeit zur Aktivierung verschiedener Testmodi gemäß Figur 3 dargestellt, wobei zur Darstellung der zeitlichen Signalverläufe beispielhaft eine Versorgungsspannung von U_{VDD}=5V und eine Referenzspannung von U_{VREF}=1V angenommen werden und die Zeitpunkte 1 bis 7 mit eingekreisten Ziffern gekennzeichnet sind.

Wie in Figur 4 dargestellt ist, treten am Test-Pin teilweise höhere Spannungen auf als von dem nachfolgenden Schmitt-Trigger verarbeitet werden können, beispielsweise bis zu 20 V. Die aus den Komponenten M₆, M₇, M₈, Mg, R₅ und R₆ gebildete Schaltung, welche in Figur 2 abgebildet ist, schützt den Eingang des Schmitt-Triggers SMT₂ vor diesen hohen Spannungen.

Zum Zeitpunkt 1 ändert die Spannung U_{TEST} ihren Wert von 0 V auf 5 V. Entsprechend ist der Ausgang des Schmitt-Triggers SMT₁ auf HIGH und der des Inverters X₉ auf LOW (CLR_FF=LOW).

Zum Zeitpunkt 2 ändert die Spannung U_{TEST} ihren Wert kurzzeitig von 5 V auf 20 V (und anschließend wieder auf 5 V). Entsprechend ist der Ausgang des Schmitt-Triggers SMT₂ (kurzzeitig) HIGH und der des D-Flipflop FF₃ wechselt von LOW auf HIGH. Die Komparatoren CMP₁ und CMP₂ werden damit aktiviert.

Zum Zeitpunkt 3 ändert die Spannung U_{TEST} ihren Wert von 5 V auf 2.5 V. Entsprechend wechseln der Ausgang des Komparators CMP₂ zeitlich verzögert von LOW auf HIGH (CMPB=HIGH) und der des Komparators CMP₁ gegenüber CMP₂ zeitlich verzögert ebenfalls von LOW auf HIGH (CMPA=HIGH). Entsprechend wechseln der Ausgang des D-Flipflops FF₄ von LOW auf HIGH (CMPA_Q=HIGH) und der Ausgang des ODER-Gatters X₁₅ wechselt von LOW auf HIGH (CMPB_H=HIGH).

Zum Zeitpunkt 4 ändert die Spannung U_{TEST} ihren Wert von 2.5 V auf 5 V. Entsprechend wechseln der Ausgang des Komparators CMP₁ zeitlich verzögert von HIGH auf LOW (CMPA=LOW) und der des Komparators CMP₂ gegenüber CMP₁ zeitlich verzögert ebenfalls von HIGH auf LOW (CMPB=LOW). Aufgrund des Verzögerungsgliedes, bestehend aus den Transistoren M₁₂ und M₁₃, dem Widerstand R₁₂ und dem Kondensator C₃, wechselt der Ausgang des ODER-Gatters X₁₅ gegenüber dem des Komparators CMP₂ zeitlich verzögert von HIGH auf LOW (CMPB_H=LOW). Mit CMPB_H=LOW werden der Ausgang des ODER-Gatters X₁₂ auf HIGH und der des D-Flipflops FF₄ auf LOW gesetzt, weil das HIGH-Signal von X₁₂ an seinem CLR-Eingang (clear) anliegt. Während CMPB schon LOW ist und CMPB_H noch HIGH ist, ist der Ausgang des UND-Gatters X₁₃ kurzzeitig HIGH (CMPB_P kurzzeitig HIGH). Weil der Ausgang des D-Flipflops FF₄ zum Zeitpunkt 3 auf HIGH gesetzt wurde, entsteht am Ausgang des UND-Gatters X₁₁ ebenfalls ein kurzer HIGH-Puls, welcher den Zähler, bestehend aus den D-Flipflops FF₅ und FF₆ inkrementiert und damit vom Testmodus 00 in den Testmodus 01 umschaltet. Die entsprechenden Ausgangssignale MD₀ und MD₁ können im ASIC verwendet werden, um bestimmte Test-Bedingungen zu schaffen. Anstelle des vorliegend aus den D-Flipflops FF₅ und FF₆ bestehenden Zählers, welcher auch in Figur 3 dargestellt ist, könnte ebenfalls ein Schieberegister zur Einstellung eines Testmodus verwendet werden, wobei die Unterscheidung zwischen einer 0 und einer 1 durch kurze und lange Pulse erfolgen könnte.

Zum Zeitpunkt 5 ändert die Spannung U_{TEST} ihren Wert von 5 V auf 3.5 V. Entsprechend wechselt (nur) der Ausgang des Komparators CMP₂ zeitlich verzögert von LOW auf HIGH (CMPB=HIGH). Entsprechend wechselt der Ausgang des ODER-Gatter X₁₅ von LOW auf HIGH (CMPB_H=HIGH).

Zum Zeitpunkt 6 ändert die Spannung U_{TEST} ihren Wert von 3.5 V auf 5 V. Entsprechend wechselt der Ausgang des Komparators CMP₂ zeitlich verzögert von HIGH auf LOW (CMPB=LOW). Aufgrund des Verzögerungsgliedes (M₁₂, M₁₃, R₁₂, C₃) wechselt der Ausgang des ODER-Gatters X₁₅ gegenüber dem des Komparators CMP₂ zeitlich verzögert von HIGH auf LOW (CMPB_H=LOW). Während CMPB schon LOW ist und CMPB_H noch HIGH ist, ist der Ausgang des UND-Gatters X₁₃ kurzzeitig HIGH (CMPB_P kurzzeitig HIGH). Weil der Ausgang des D-Flipflops FF₄ zum Zeitpunkt 4 auf LOW gesetzt wurde, entsteht am Ausgang des UND-Gatters X₁₀ ebenfalls ein kurzer HIGH-Puls, der den Zähler, bestehend aus den D-Flipflops FF₁ und FF₂ von 00 auf 01 inkrementiert und damit, wie entsprechend für Figur 2 beschrieben, das analoge Signal A₁ über das Transmission-Gate TG₁ auf den Operationsverstärker OP₁ schaltet, sodass dieses über den ASIC-Test-Pin TEST messtechnisch erfassbar wird.

Zum Zeitpunkt 7 ändert die Spannung U_{TEST} ihren Wert kurzzeitig von 5 V auf 20 V (und danach wieder auf 5 V). Entsprechend ist der Ausgang des Schmitt-Triggers SMT₂ (kurzzeitig) HIGH und der des D-Flipflops FF₃ wechselt von HIGH auf LOW. Die Komparatoren CMP₁ und CMP₂ werden damit deaktiviert. Nun wäre beispielsweise über den ASIC-Anschluss TEST messtechnisch erfassbar, ab welcher internen Versorgungsspannung U_{VDD} die interne Referenzspannung U_{VREF} ihren Zielwert erreicht oder ein internes Power-on-Reset-Signal seinen Zustand ändert, ohne dass die Gefahr bestünde, dass einer der Komparatoren ungewollt schalten könnte.

Im weiteren zeitlichen Verlauf nach dem Zeitpunkt 7 ist in Figur 4 dargestellt, dass ein Wechsel der Spannung U_{TEST} von 5 V auf 2.5 V nun keinen Einfluss mehr auf die Komparatoren CMP₁ und CMP₂ und damit auch keinen Einfluss mehr auf den Zustand der D-Flipflops hat. Wird die Spannung U_{TEST} auf 0 V gesetzt, so wird der Testmodus ganz verlassen und alle D-Flipflops werden zurückgesetzt.

## Patentansprüche

1. Elektrische Schaltung zum Test primärer interner Signale eines ASIC, wobei lediglich ein Test-Pin (TEST) vorgesehen ist, über welchen eine Auswahl zu beobachtender digitaler Signale (D₁, D₂, ..., Dₙ) oder eines analogen Signals (A₁, A₂, ..., Aₘ) durchführbar ist, **dadurch gekennzeichnet, dass**
- zwischen dem Test-Pin (TEST) und einem Ausgangsanschluss (TM) der elektrischen Schaltung ein Schmitt-Trigger (SMT₁) angeordnet ist, wobei bei einem Überschreiten einer Schaltschwelle des Schmitt-Triggers (SMT₁) eine Aktivierung eines Testmodus vorgesehen ist, und
- zur Beobachtung eines digitalen Signals (D₁, D₂, ..., Dₙ) wenigstens eine Teilschaltung mit einem Widerstand (R₁, R₂, ..., Rₙ), einem NMOS-Transistor (M₁, M₂, ..., Mₙ) sowie einem ein UND-Gatter (X₁, X₂, ..., Xₙ) vorgesehen ist, an dessen ersten Eingang das digitale Signal (D₁, D₂, ..., Dₙ) anliegt, wobei der Widerstand (R₁, R₂, ..., Rₙ) zwischen dem Test-Pin (TEST) und dem Drain-Anschluss des NMOS-Transistors (M₁, M₂, ..., Mₙ) angeordnet ist, der Source-Anschluss des NMOS-Transistors (M₁, M₂, ..., Mₙ) mit Masse (GND) verbunden ist, der Gate-Anschluss des NMOS-Transistors (M₁, M₂, ..., Mₙ) mit dem Ausgang des UND-Gatters (X₁, X₂, ..., Xₙ) verbunden ist und der zweite Eingang des UND-Gatters (X₁, X₂, ..., Xₙ) mit dem Ausgangsanschluss (TM) der elektrischen Schaltung verbunden ist.

2. Elektrische Schaltung nach Anspruch 1, wobei ein am Test-Pin (TEST) messbarer Strom aufgrund der Zustände aller digitalen Signale (D₁, D₂, ..., Dₙ) oder eines ausgewählten analogen Signals (A₁, A₂, ..., Aₘ) bestimmbar ist und mittels des messbaren Stroms auf den Zustand aller digitalen Signale (D₁, D₂, ..., Dₙ) oder auf den Zustand des ausgewählten analogen Signals (A₁, A₂, ..., Aₘ) schließbar ist.

3. Elektrische Schaltung nach Anspruch 1 oder Anspruch 2, ferner umfassend einen zwischen dem Test-Pin (TEST) und Masse (GND) angeordneten Widerstand (Ro).

4. Elektrische Schaltung nach einem der Ansprüche 1 bis 3, wobei entsprechend der Berechnung Ro=2°xR, R₁=2¹×R, R₂=2²×R, ..., Rₙ=2ⁿ×R dimensionierte Widerstände (R₁, R₂, ..., Rₙ) vorgesehen sind.

5. Elektrische Schaltung nach einem der Ansprüche 1 bis 4, ferner ausgebildet zur Beobachtung von analogen Signalen (A₁, A₂, ..., Aₘ), umfassend
- einen Operationsverstärker (OP₁),
- eine einen Schmitt-Trigger (SMT₂) aufweisende Schaltung zur Begrenzung der Eingangsspannung am Test-Pin,
- wenigstens eine zur Beobachtung des analogen Signals (A₁, A₂, ..., Aₘ) vorgesehene Teilschaltung.

6. Elektrische Schaltung nach Anspruch 5, wobei die zur Beobachtung des analogen Signals (A₁, A₂, ..., Aₘ) vorgesehene Teilschaltung
- einen wenigstens zwei D-Flipflops (FF₁, FF₂, ..., FF_{d}) aufweisenden Zähler, und
- für jedes zu beobachtende analoge Signal (A₁, A₂, ..., Aₘ) einen ein UND-Gatter (X₅, X₆, X₇) aufweisenden Decoder sowie ein Transmissionsgatter (TG₁, TG₂, TG₃)
umfasst.

7. Elektrische Schaltung nach Anspruch 5 oder Anspruch 6, wobei ein erster Eingang des jeweiligen UND-Gatters (X₅, X₆, X₇) mit dem nicht-invertierten Ausgang (Q) bzw. dem invertierten Ausgang (Q') eines ersten der D-Flipflops (FF₁), ein zweiter Eingang des jeweiligen UND-Gatters (X₅, X₆, X₇) mit dem nicht-invertierten Ausgang (Q) bzw. dem invertierten Ausgang (Q') eines zweiten der D-Flipflops (FF₂) und der Ausgang des jeweiligen UND-Gatters (X₅, X₆, X₇) mit einem Eingang (EN) zur Steuerung des jeweiligen Transmissionsgatters (TG₁, TG₂, TG₃) verbunden sind.

8. Elektrische Schaltung nach einem der Ansprüche 5 bis 7, wobei ferner ein ODER-Gatter (X₈) vorgesehen ist, dessen erster Eingang mit dem nicht-invertierten Ausgang (Q) des ersten der wenigstens zwei D-Flipflops (FF₁, FF₂), dessen zweiter Eingang mit dem nicht-invertierten Ausgang (Q) des zweiten der wenigstens zwei D-Flipflops und dessen Ausgang mit einem Eingang (EN) zur Steuerung des Operationsverstärkers (OP₁) verbunden sind.

9. Elektrische Schaltung nach einem der Ansprüche 5 bis 8, wobei ferner ein UND-Gatter (X₄) vorgesehen ist, dessen erster Eingang mit dem invertierten Ausgang (Q') des ersten der wenigstens zwei D-Flipflops, dessen zweiter Eingang mit dem invertierten Ausgang (Q') des zweiten der wenigstens zwei D-Flipflops verbunden ist, dessen dritter Eingang mit dem Ausgang des Schmitt-Triggers SMT₁ verbunden ist und dessen Ausgang mit einem jeweils dritten Eingang des wenigstens einen UND-Gatters (X₁, X₂, X₃), welches in der für die Beobachtung eines digitalen Signals (D₁, D₂, D₃, Dₙ) vorgesehenen Teilschaltung angeordnet ist, verbunden ist.

10. Elektrische Schaltung nach einem der Ansprüche 5 bis 9, wobei bei der einen Schmitt-Trigger (SMT₂) aufweisenden Schaltung zur Begrenzung der Eingangsspannung am Test-Pin (TEST) deren Eingang zwischen zwei Widerständen (R₇, R₈) eines zwischen Test-Pin (TEST) der elektrischen Schaltung und Masse (GND) angeordneten Spannungsteilers angeordnet ist und deren Ausgang mit dem Taktsignal-Eingang (CLK) eines D-Flipflops (FF₂; FF₃) verbunden ist.

11. Elektrische Schaltung nach einem der Ansprüche 5 bis 10, wobei der Ausgangsanschluss (TM) der elektrischen Schaltung mittels eines Inverters (X₉) invertiert ist und jeweils mit einem Clear-Eingang (CLR) eines D-Flipflops (FF₁, FF₂; FF₁, FF₂, FF₃, FF₅, FF₆) verbunden ist.

12. Elektrische Schaltung nach einem der Ansprüche 5 bis 11, ferner umfassend zwei Komparatoren (CMP₁, CMP₂) zur Auswahl der zu messenden digitalen (D₁, D₂, ..., Dₙ) oder analogen (A₁, A₂, ..., Aₘ) Signale über den Test-Pin (TEST) und zur Aktivierung unterschiedlicher Testmodi.

13. Elektrische Schaltung nach Anspruch 12, wobei an dem positiven Eingang der Komparatoren (CMP₁, CMP₂) jeweils eine Referenzspannung (UVREF) anliegt und der negative Eingang der Komparatoren (CMP₁, CMP₂) jeweils mit dem Test-Pin (TEST) verbunden ist.

14. Elektrische Schaltung nach Anspruch 13, wobei zwischen dem negativen Eingang der Komparatoren (CMP₁, CMP₂) und dem Test-Pin (TEST) der elektrischen Schaltung jeweils eine aus einem Transistor (M₁₀, M₁₁) sowie aus einem Widerstand (R₁₀, R₁₁) und einem Kondensator (C₁, C₂) bestehende Schaltung vorgesehen ist.

15. Elektrische Schaltung nach einem der Ansprüche 12 bis 14, wobei ferner ein D-Flipflop (FF₃) vorgesehen ist, dessen Taktsignal-Eingang (CLK) mit dem Ausgang des Schmitt-Triggers (SMT₂) verbunden ist und dessen nicht-invertierter Ausgang (Q) jeweils mit einem Eingang (EN) zur Steuerung des jeweiligen Komparators (CMP₁, CMP₂) verbunden ist.

16. Elektrische Schaltung nach einem der Ansprüche 12 bis 15, ferner umfassend zwei D-Flipflops (FF₅, FF₆), welche zur Bereitstellung von Ausgangssignalen (MDo, MD₁) vorgesehen sind.

17. Elektrische Schaltung nach einem der Ansprüche 12 bis 15, ferner umfassend ein aus D-Flipflops (FF₁, FF₂; FF₅, FF₆) bestehendes Schieberegister zur Auswahl der zu testenden Signale (D₁, D₂, D₃; A₁, A₂, A₃) und zur Einstellung eines Test-Modes (00 - 11).

## Claims

1. Electrical circuit for testing primary internal signals of an ASIC, wherein only one test pin (TEST) is provided, via which it is possible to select digital signals (D₁, D₂, ..., Dₙ) to be observed or an analogue signal (A₁, A₂, ..., Aₘ), **characterized in that**
- a Schmitt trigger (SMT₁) is arranged between the test pin (TEST) and an output connection (TM) of the electrical circuit, wherein provision is made to activate a test mode if a switching threshold of the Schmitt trigger (SMT₁) is exceeded, and
- at least one sub-circuit with a resistor (R₁, R₂, ..., Rₙ), an NMOS transistor (M₁, M₂, ..., Mₙ) and an AND gate (X₁, X₂, ..., Xₙ), the first input of which has the digital signal (D₁, D₂, ..., Dₙ) applied to it, is provided for observing a digital signal (D₁, D₂, ..., Dₙ), wherein the resistor (R₁, R₂, ..., Rₙ) is arranged between the test pin (TEST) and the drain connection of the NMOS transistor (M₁, M₂, ..., Mₙ), the source connection of the NMOS transistor (M₁, M₂, ..., Mₙ) is connected to earth (GND), the gate connection of the NMOS transistor (M₁, M₂, ..., Mₙ) is connected to the output of the AND gate (X₁, X₂, ..., Xₙ) and the second input of the AND gate (X₁, X₂, ..., Xₙ) is connected to the output connection (TM) of the electrical circuit.

2. Electrical circuit according to Claim 1, wherein a current that can be measured at the test pin (TEST) can be determined on the basis of the states of all the digital signals (D₁, D₂, ..., Dₙ) or of a selected analogue signal (A₁, A₂, ..., Aₘ) and the state of all the digital signals (D₁, D₂, ..., Dₙ) or the state of the selected analogue signal (A₁, A₂, ..., Aₘ) can be deduced by means of the current that can be measured.

3. Electrical circuit according to Claim 1 or Claim 2, also comprising a resistor (Ro) arranged between the test pin (TEST) and earth (GND).

4. Electrical circuit according to one of Claims 1 to 3, wherein resistors (R₁, R₂, ..., Rₙ) dimensioned in accordance with the calculation R₀=2⁰×R, R₁=2¹×R, R₂=2²×R, ..., Rₙ=2ⁿ×R are provided.

5. Electrical circuit according to one of Claims 1 to 4, also designed to observe analogue signals (A₁, A₂, ..., Aₘ), comprising
- an operational amplifier (OP₁),
- a circuit, having a Schmitt trigger (SMT₂), for limiting the input voltage at the test pin,
- at least one sub-circuit provided for observing the analogue signal (A₁, A₂, ..., Aₘ).

6. Electrical circuit according to Claim 5, wherein the sub-circuit provided for observing the analogue signal (A₁, A₂, ..., Aₘ) comprises
- a counter having at least two D-type flip-flops (FF₁, FF₂, ..., FF_{d}), and
- a decoder, having an AND gate (X₅, X₆, X₇), and a transmission gate (TG₁, TG₂, TG₃) for each analogue signal (A₁, A₂, ..., Aₘ) to be observed.

7. Electrical circuit according to Claim 5 or Claim 6, wherein a first input of the respective AND gate (X₅, X₆, X₇) is connected to the non-inverted output (Q) or the inverted output (Q') of a first one of the D-type flip-flops (FF₁), a second input of the respective AND gate (X₅, X₆, X₇) is connected to the non-inverted output (Q) or the inverted output (Q') of a second one of the D-type flip-flops (FF₂) and the output of the respective AND gate (X₅, X₆, X₇) is connected to an input (EN) for controlling the respective transmission gate (TG₁, TG₂, TG₃) .

8. Electrical circuit according to one of Claims 5 to 7, wherein an OR gate (X₈) is also provided, the first input of which is connected to the non-inverted output (Q) of the first one of the at least two D-type flip-flops (FF₁, FF₂), the second input of which is connected to the non-inverted output (Q) of the second one of the at least two D-type flip-flops and the output of which is connected to an input (EN) for controlling the operational amplifier (OP₁).

9. Electrical circuit according to one of Claims 5 to 8, wherein an AND gate (X₄) is also provided, the first input of which is connected to the inverted output (Q') of the first one of the at least two D-type flip-flops, the second input of which is connected to the inverted output (Q') of the second one of the at least two D-type flip-flops, the third input of which is connected to the output of the Schmitt trigger (SMT₁) and the output of which is connected to a respective third input of the at least one AND gate (X₁, X₂, X₃) that is arranged in the sub-circuit provided for observing a digital signal (D₁, D₂, D₃, Dₙ).

10. Electrical circuit according to one of Claims 5 to 9, wherein, in the case of the circuit, having a Schmitt trigger (SMT₂), for limiting the input voltage at the test pin (TEST), the input thereof is arranged between two resistors (R₇, R₈) of a voltage divider arranged between the test pin (TEST) of the electrical circuit and earth (GND), and the output thereof is connected to the clock signal input (CLK) of a D-type flip-flop (FF₂; .

11. Electrical circuit according to one of Claims 5 to 10, wherein the output connection (TM) of the electrical circuit is inverted by means of an inverter (Xg) and is respectively connected to a clear input (CLR) of a D-type flip-flop (FF₁, FF₂; FF₁, FF₂, FF₃, FF₅, FF₆).

12. Electrical circuit according to one of Claims 5 to 11, also comprising two comparators (CMP₁, CMP₂) for selecting the digital (D₁, D₂, ..., Dₙ) or analogue (A₁, A₂, ..., Aₘ) signals to be measured via the test pin (TEST) and for activating different test modes.

13. Electrical circuit according to Claim 12, wherein a respective reference voltage (U_{VREF}) is present at the positive input of the comparators (CMP₁, CMP₂) and the negative input of the comparators (CMP₁, CMP₂) is respectively connected to the test pin (TEST).

14. Electrical circuit according to Claim 13, wherein a respective circuit consisting of a transistor (M₁₀, M₁₁) and of a resistor (R₁₀, R₁₁) and a capacitor (C₁, C₂) is provided between the negative input of the comparators (CMP₁, CMP₂) and the test pin (TEST) of the electrical circuit.

15. Electrical circuit according to one of Claims 12 to 14, wherein a D-type flip-flop (FF₃) is also provided, the clock signal input (CLK) of which is connected to the output of the Schmitt trigger (SMT₂) and the non-inverted output (Q) of which is respectively connected to an input (EN) for controlling the respective comparator (CMP₁, CMP₂).

16. Electrical circuit according to one of Claims 12 to 15, also comprising two D-type flip-flops (FF₅, FF₆) that are provided for providing output signals (MDo, MD₁).

17. Electrical circuit according to one of Claims 12 to 15, also comprising a shift register consisting of D-type flip-flops (FF₁, FF₂; FF₅, FF₆) for selecting the signals (D₁, D₂, D₃; A₁, A₂, A₃) to be tested and for setting a test mode (00-11).

## Revendications

1. Circuit électrique pour tester des signaux internes primaires d'un ASIC, dans lequel seule une broche de test (TEST) est prévue par laquelle une sélection de signaux numériques (D₁, D₂, ..., Dₙ) à observer ou d'un signal analogique (A₁, A₂, ..., Aₘ) peut être effectuée,
**caractérisé en ce que**
- entre la broche de test (TEST) et une borne de sortie (TM) du circuit électrique, une bascule de Schmitt (SMT₁) est disposée, une activation d'un mode test étant prévue en cas de dépassement d'un seuil de commutation de la bascule de Schmitt (SMT₁), et
- pour observer un signal numérique (D₁, D₂, ..., Dₙ), au moins un circuit partiel doté d'une résistance (R₁, R₂, ..., Rₙ), d'un transistor NMOS (M₁, M₂, ..., Mₙ) ainsi que d'une porte ET (X₁, X₂, ..., Xₙ) est prévu à la première entrée duquel est appliqué le signal numérique (D₁, D₂, ..., Dₙ),
la résistance (R₁, R₂, ..., Rₙ) étant disposée entre la broche de test (TEST) et la borne de drain du transistor NMOS (M₁, M₂, ..., Mₙ), la borne de source du transistor NMOS (M₁, M₂, ..., Mₙ) étant reliée à la masse (GND), la borne de grille du transistor NMOS (M₁, M₂, ..., Mₙ) étant reliée à la sortie de la porte ET (X₁, X₂, ..., Xₙ), et la deuxième entrée de la porte ET (X₁, X₂, ..., Xₙ) étant reliée à la borne de sortie (TM) du circuit électrique.

2. Circuit électrique selon la revendication 1, dans lequel un courant mesurable à la broche de test (TEST) peut être déterminé en raison des états de tous les signaux numériques (D₁, D₂, ..., Dₙ) ou d'un signal analogique sélectionné (A₁, A₂, ..., Aₘ), et le courant mesurable permet de conclure à l'état de tous les signaux numériques (D₁, D₂, ..., Dₙ) ou à l'état du signal analogique sélectionné (A₁, A₂, ..., Aₘ).

3. Circuit électrique selon la revendication 1 ou 2, comprenant en outre une résistance (Ro) disposée entre la broche de test (TEST) et la masse (GND).

4. Circuit électrique selon l'une quelconque des revendications 1 à 3, dans lequel des résistances (R₁, R₂, ..., Rₙ) dimensionnées selon le calcul R₀ = 2⁰×R, R₁ = 2¹×R, R₂ = 2²×R, ..., Rₙ = 2ⁿ×R sont prévues.

5. Circuit électrique selon l'une quelconque des revendications 1 à 4, en outre réalisé pour observer des signaux analogiques (A₁, A₂, ..., Aₘ), comprenant
- un amplificateur opérationnel (OP₁),
- un circuit présentant une bascule de Schmitt (SMT₂) pour limiter la tension d'entrée à la broche de test,
- au moins un circuit partiel prévu pour l'observation du signal analogique (A₁, A₂, ..., Aₘ).

6. Circuit électrique selon la revendication 5, dans lequel le circuit partiel prévu pour l'observation du signal analogique (A₁, A₂, ..., Aₘ) comprend
- un compteur présentant au moins deux bascules D (FF₁, FF₂, ..., FF_{d}), et
- pour chaque signal analogique (A₁, A₂, ..., Aₘ) à observer un décodeur présentant une porte ET (X₅, X₆, X₇) ainsi qu'une porte de transmission (TG₁, TG₂, TG₃) .

7. Circuit électrique selon la revendication 5 ou 6, dans lequel une première entrée de la porte ET (X₅, X₆, X₇) respective est reliée à la sortie non inverseuse (Q) ou à la sortie inverseuse (Q') d'une première des bascules D (FF₁), une deuxième entrée de la porte ET (X₅, X₆, X₇) respective est reliée à la sortie non inverseuse (Q) ou à la sortie inverseuse (Q') d'une deuxième des bascules D (FF₂), et la sortie de la porte ET (X₅, X₆, X₇) respective est reliée à une entrée (EN) permettant de commander la porte de transmission (TG₁, TG₂, TG₃) respective.

8. Circuit électrique selon l'une quelconque des revendications 5 à 7, dans lequel en outre une porte OU (X₈) est prévue dont la première entrée est reliée à la sortie non inverseuse (Q) de la première des au moins deux bascules D (FF₁, FF₂), dont la deuxième entrée est reliée à la sortie non inverseuse (Q) de la deuxième des au moins deux bascules D, et dont la sortie est reliée à une entrée (EN) permettant de commander l'amplificateur opérationnel (OP₁).

9. Circuit électrique selon l'une quelconque des revendications 5 à 8, dans lequel en outre une porte ET (X₄) est prévue dont la première entrée est reliée à la sortie inverseuse (Q') de la première des au moins deux bascules D, dont la deuxième entrée est reliée à la sortie inverseuse (Q') de la deuxième des au moins deux bascules D, dont la troisième entrée est reliée à la sortie de la bascule de Schmitt SMT₁, et dont la sortie est reliée à une troisième entrée respectivement de ladite au moins une porte ET (X₁, X₂, X₃) qui est disposée dans le circuit partiel prévu pour l'observation d'un signal numérique (D₁, D₂, D₃, Dₙ).

10. Circuit électrique selon l'une quelconque des revendications 5 à 9, dans lequel, sur le circuit présentant une bascule de Schmitt (SMT₂) pour limiter la tension d'entrée à la broche de test (TEST), l'entrée de celui-ci est disposée entre deux résistances (R₇, R₈) d'un diviseur de tension disposé entre la broche de test (TEST) du circuit électrique et la masse (GND), et la sortie de celui-ci est reliée à l'entrée de signal d'horloge (CLK) d'une bascule D (FF₂ ; FF₃).

11. Circuit électrique selon l'une quelconque des revendications 5 à 10, dans lequel la borne de sortie (TM) du circuit électrique est inversée au moyen d'un inverseur (Xg), et est reliée respectivement à une entrée CLEAR (CLR) d'une bascule D (FF₁, FF₂ ; FF₁, FF₂, FF₃, FF₅, FF₆).

12. Circuit électrique selon l'une quelconque des revendications 5 à 11, comprenant en outre deux comparateurs (CMP₁, CMP₂) permettant de sélectionner les signaux numériques (D₁, D₂, ..., Dₙ) ou analogiques (A₁, A₂, ..., Aₘ) à mesurer par l'intermédiaire de la broche de test (TEST) et d'activer différents modes de test.

13. Circuit électrique selon la revendication 12, dans lequel à l'entrée positive des comparateurs (CMP₁, CMP₂), respectivement une tension de référence (UVREF) est appliquée, et l'entrée négative des comparateurs (CMP₁, CMP₂) est reliée respectivement à la broche de test (TEST).

14. Circuit électrique selon la revendication 13, dans lequel, entre l'entrée négative des comparateurs (CMP₁, CMP₂) et la broche de test (TEST) du circuit électrique, respectivement un circuit composé d'un transistor (M₁₀, M₁₁) ainsi que d'une résistance (R₁₀, R₁₁) et d'un condensateur (C₁, C₂) est prévu.

15. Circuit électrique selon l'une quelconque des revendications 12 à 14, dans lequel en outre une bascule D (FF₃) est prévue dont l'entrée de signal d'horloge (CLK) est reliée à la sortie de la bascule de Schmitt (SMT₂) et dont la sortie non inverseuse (Q) est reliée respectivement à une entrée (EN) permettant de commander le comparateur (CMP₁, CMP₂) respectif.

16. Circuit électrique selon l'une quelconque des revendications 12 à 15, comprenant en outre deux bascules D (FF₅, FF₆) qui sont prévues pour fournir des signaux de sortie (MDo, MD₁).

17. Circuit électrique selon l'une quelconque des revendications 12 à 15, comprenant en outre un registre à décalage composé de bascules D (FF₁, FF₂ ; FF₅, FF₆) permettant de sélectionner les signaux à tester (D₁, D₂, D₃ ; A₁, A₂, A₃) et de régler un mode de test (00 - 11) .
